(19) Europäisches Patentamt
European Patent Office
Office européen des brevets

(11) EP 4 163 962 A1

(12) EUROPEAN PATENT APPLICATION
published in accordance with Art. 153(4) EPC

(43) Date of publication:
**12.04.2023 Bulletin 2023/15**

(21) Application number: **21816974.6**

(22) Date of filing: **01.06.2021**

(51) International Patent Classification (IPC):
***H01L 23/36*** *(2006.01)* ***C08K 5/5425*** *(2006.01)*
***C08L 83/05*** *(2006.01)* ***C08L 83/07*** *(2006.01)*
***C09K 5/14*** *(2006.01)* ***C08K 3/08*** *(2006.01)*
***C08K 3/22*** *(2006.01)* ***C08K 3/28*** *(2006.01)*
***C08K 3/38*** *(2006.01)*

(52) Cooperative Patent Classification (CPC):
**C08K 3/08; C08K 3/22; C08K 3/28; C08K 3/38; C08K 5/5425; C08L 83/04; C09K 5/14; H01L 23/36**

(86) International application number:
**PCT/JP2021/020817**

(87) International publication number:
**WO 2021/246397 (09.12.2021 Gazette 2021/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **05.06.2020 JP 2020098753**

(71) Applicant: **Denka Company Limited**
**Tokyo 103-8338 (JP)**

(72) Inventor: **KATO, Masahiro**
**Tokyo 103-8338 (JP)**

(74) Representative: **Zacco Sweden AB**
**P.O. Box 5581**
**Löjtnantsgatan 21**
**114 85 Stockholm (SE)**

# (54) TWO-PACK CURABLE HEAT CONDUCTIVE GREASE COMPOSITION, HEAT CONDUCTIVE GREASE AND ELECTRONIC DEVICE

(57) A two-agent curable heat conductive grease composition including a first agent and a second agent, wherein the first agent contains 100 parts by weight of a liquid resin (A-1), 140 parts by weight to 560 parts by weight of metal aluminum (B-1) having an average particle size of 15 to 100 μm, one or more heat conductive fillers (C-1) selected from the group consisting of aluminum oxide, aluminum nitride, and boron nitride and having an average particle size within a range of 0.3 to 10 μm, and a hydrosilylation reaction catalyst (D-1); the second agent contains 100 parts by weight of a liquid resin (A-2), 140 parts by weight to 560 parts by weight of metal aluminum (B-2) having an average particle size of 15 to 100 μm, and one or more heat conductive fillers (C-2) selected from the group consisting of aluminum oxide, aluminum nitride, and boron nitride and having an average particle size within a range of 0.3 to 10 μm, and at least one of the heat conductive filler (C-1) or the heat conductive filler (C-2) includes a first heat conductive filler (C-1-1) or a first heat conductive filler (C-2-1) being at least one or more selected from the group consisting of aluminum oxide, aluminum nitride, and boron nitride and having an average particle size of 0.3 to 1.5 μm.



Processed by Luminess, 75001 PARIS (FR)

## Description

Technical Field

The present invention relates to a two-agent curable heat conductive grease composition, a heat conductive grease, and an electronic device.

Background Art

Along with miniaturization and high output of heat generating electronic components such as CPU (central processing unit) of personal computers, the quantity of heat per unit area generated from those electronic components has been significantly increasing. The quantity of heat thereof reaches as much as about 20 times of the quantity of heat of clothes irons. To prevent these heat generating electronic components from breaking down over a long period, cooling of heat generating electronic components is required. Heat sinks and casings made of metal are used for cooling, and furthermore, heat conductive materials are used to efficiently transmit the heat from heat generating electronic components to the cooling member such as heat sinks and casings. The reason for using heat conductive materials is as follows; when a heat generating electronic component and a heat sink and the like are brought into contact without any heat conductive material, air is present in the interface thereof when being microscopically observed, resulting in an obstacle to heat conduction. Therefore, the heat is efficiently transmitted by allowing the heat conductive material to be present between a heat generating electronic component and a heat sink instead of the air being present in the interface.

Examples of heat conductive materials include heat conductive pads and heat conductive sheets obtained by filling a thermosetting resin with heat conductive powder and forming into a sheet, heat conductive grease obtained by filling a fluid resin with heat conductive powder and capable of being coated and made into a thin film, and phase change type heat conductive materials that soften or fluidize at operating temperatures of the heat generating electronic component.

In recent years, the temperature of devices is 200°C or more along with an increase in speed and miniaturization due to SiC and GaN power semiconductors, so that use of the heat conductive grease has been increasing from the viewpoint of a large need for high heat conduction of the heat conductive material and being capable of reducing the thickness to be used.

However, if a large amount of metal aluminum powder, copper powder, silver powder, and the like that are electrically conductive fillers having high heat conductivity is mixed to improve the heat conductivity, the heat conductivity of the heat conductive grease can be improved, but the insulating properties deteriorate, so that the grease cannot be used for applications of electronic devices which require insulating properties. Moreover, if a large amount of powder of alumina, aluminum nitride, silica, and the like that are insulating fillers is mixed to improve the heat conductivity, the insulating properties are secured, but the viscosity of the heat conductive grease largely increases, making coating upon application difficult.

Patent Literature 1 describes a heat conductive grease including fine aluminum powder and fine powder alumina different in average particle size as essential components to reduce heat resistance, and Patent Literature 2 suggests a heat conductive grease containing metal aluminum, aluminum nitride, and zinc oxide as essential components, but does not mention the presence or absence of insulating properties. In contrast, Patent Literature 3 describes that a heat conductive silicone grease composition having excellent heat conductivity and electrical insulating properties can be obtained by optimizing the amount blended of metal powder and the amount blended of zinc oxide powder relative to liquid silicone. However, zinc oxide powder has a large specific surface area and when it is highly filled in the liquid silicone, the viscosity increases, resulting in a poor coated surface.

Citation List

Patent Literature

Patent Literature 1: Japanese Patent Laid-Open No. 2005-170971
Patent Literature 2: Japanese Patent Laid-Open No. 2010-248669
Patent Literature 3: Japanese Patent Laid-Open No. 2007-099821

Summary of Invention

Technical Problem

The present invention has been made in view of the above problems, and an object of the present invention is to provide a two-agent curable heat conductive grease composition that has a low viscosity, is excellent in application properties, and achieves both high heat conductivity and electrical insulating properties, a heat conductive grease, and an electronic device using the heat conductive grease.

Solution to Problem

The present inventors have intensively studied to achieve the above object, and as a result, have found that the above problems can be solved by mixing metal aluminum powder having a specific average particle size and a heat conductive filler having a specific average particle size in a two-agent curable heat conductive grease composition at an appropriate mixing ratio, thereby leading to the accomplishment of the present invention.
That is, the present invention is as follows.

[1] A two-agent curable heat conductive grease composition including a first agent and a second agent, wherein

the first agent contains 100 parts by weight of a liquid resin (A-1), 140 parts by weight to 560 parts by weight of metal aluminum (B-1) having an average particle size of 15 to 100 μm, one or more heat conductive fillers (C-1) selected from the group consisting of aluminum oxide, aluminum nitride, and boron nitride and having an average particle size within a range of 0.3 to 10 μm, and a hydrosilylation reaction catalyst (D-1);
the second agent contains 100 parts by weight of a liquid resin (A-2), 140 parts by weight to 560 parts by weight of metal aluminum (B-2) having an average particle size of 15 to 100 μm, and one or more heat conductive fillers (C-2) selected from the group consisting of aluminum oxide, aluminum nitride, and boron nitride and having an average particle size within a range of 0.3 to 10 μm; and
at least one of the heat conductive filler (C-1) or the heat conductive filler (C-2) includes a first heat conductive filler (C-1-1) or a first heat conductive filler (C-2-1) being at least one or more selected from the group consisting of aluminum oxide, aluminum nitride, and boron nitride and having an average particle size of 0.3 to 1.5 μm.

[2] The two-agent curable heat conductive grease composition according to [1], wherein

the liquid resin (A-1) includes a polyorganosiloxane (A-1-1) having two or more alkenyl groups in a molecule and having a viscosity at 25°C and a shear rate of 10 $s^{-1}$ of 50 to 3000 mPa·s, and
the hydrosilylation reaction catalyst (D-1) includes a platinum compound catalyst.

[3] The two-agent curable heat conductive grease composition according to [1] or [2], wherein the liquid resin (A-2) includes:

a polyorganosiloxane (A-2-1) having two or more alkenyl groups in a molecule and having a viscosity at 25°C and a shear rate of 10 $s^{-1}$ of 50 to 3000 mPa·s, and
a polyorganosiloxane (A-2-2) having three or more Si-H groups in a molecule.

[4] The two-agent curable heat conductive grease composition according to any one of [1] to [3], wherein a ratio of the sum of number of moles of the alkenyl group in the liquid resin (A-1) and the liquid resin (A-2) contained in the first agent and the second agent to number of moles of the Si-H group in the liquid resin (A-2) contained in the second agent is 0.1 to 5.0.
[5] The two-agent curable heat conductive grease composition according to any one of [1] to [4], wherein a viscosity at 25°C and a shear rate of 10 $s^{-1}$ of the first agent and the second agent is 20 Pa·s to 300 Pa·s.
[6] A heat conductive grease obtained by curing the first agent and the second agent contained in the two-agent curable heat conductive grease composition according to any one of [1] to [5].
[7] The heat conductive grease according to [6], wherein the heat conductive grease has

a heat conductivity of 0.5 W/mK or more, and
a breakdown voltage per 1 mm thickness of 1 kV or more.

[8] An electronic device including a heating generating element and a metal casing arranged via the heat conductive

grease according to [6] or [7].

Advantageous Effects of Invention

The present invention can provide a two-agent curable heat conductive grease composition that has a low viscosity, is excellent in application properties, and achieves both high heat conductivity and electrical insulating properties, a heat conductive grease, and an electronic device using the heat conductive grease.

Description of Embodiments

Hereinafter, an embodiment for implementing the present invention (hereinafter, referred to as "the present embodiment") will be described in detail, but the present invention is not limited to the embodiment, and can be implemented with various modifications within a range not departing from the gist thereof.

[Two-agent curable heat conductive grease composition]

The two-agent curable heat conductive grease composition of the present embodiment includes a first agent and a second agent. The first agent contains 100 parts by weight of a liquid resin (A-1), 140 parts by weight to 560 parts by weight of metal aluminum (B-1) having an average particle size of 15 to 100 μm, one or more heat conductive fillers (C-1) selected from the group consisting of aluminum oxide, aluminum nitride, and boron nitride and having an average particle size within a range of 0.3 to 10 μm, and a hydrosilylation reaction catalyst (D-1), and may include other components as needed. The second agent contains 100 parts by weight of a liquid resin (A-2), 140 parts by weight to 560 parts by weight of metal aluminum (B-2) having an average particle size of 15 to 100 μm, and one or more heat conductive fillers (C-2) selected from the group consisting of aluminum oxide, aluminum nitride, and boron nitride and having an average particle size within a range of 0.3 to 10 μm, and may include other components as needed.

Further, in the present embodiment, at least one of the heat conductive filler (C-1) contained in the first agent or the heat conductive filler (C-2) contained in the second agent includes a first heat conductive filler (C-1-1) or a first heat conductive filler (C-2-1) being at least one or more selected from the group consisting of aluminum oxide, aluminum nitride, and boron nitride and having an average particle size of 0.3 to 1.5 μm. The heat conductive filler having an average particle size of 0.3 to 1.5 μm contained in the first agent is referred to as the first heat conductive filler (C-1-1), and the heat conductive filler having an average particle size of 0.3 to 1.5 μm contained in the second agent is referred to as the first heat conductive filler (C-2-1) .

The viscosity at 25°C and a shear rate of 10 $s^{-1}$ of the first agent is preferably 20 to 300 Pa·s, more preferably 20 to 250 Pa·s, further preferably 20 to 200 Pa·s, and still more preferably 20 to 150 Pa·s. When the viscosity of the first agent is 20 Pa·s or more, dropping down of the heat conductive grease can be suppressed until the curing reaction occurs even when the heat conductive grease is used in a vertical placement, so that the handleability tends to be further improved. When the viscosity of the first agent is 300 Pa·s or less, the application properties tend to be further improved when the first agent and the second agent are mixed with a static mixer.

The viscosity at 25°C and a shear rate of 10 $s^{-1}$ of the second agent is preferably 20 to 300 Pa·s, more preferably 20 to 250 Pa·s, further preferably 20 to 200 Pa·s, and still more preferably 20 to 150 Pa·s. When the viscosity of the second agent is 20 Pa·s or more, dropping down of the heat conductive grease can be suppressed until the curing reaction occurs even when the heat conductive grease is used in a vertical placement, so that the handleability tends to be further improved. When the viscosity of the second agent is 300 Pa·s or less, the application properties when the first agent and the second agent are mixed with a static mixer tend to be further improved.

The viscosity at 25°C and a shear rate of 10 $s^{-1}$ when the first agent and the second agent are mixed is preferably 20 Pa·s to 300 Pa·s, more preferably 20 Pa·s to 250 Pa·s, further preferably 20 Pa·s to 200 Pa·s, and still more preferably 20Pa·s to 150 Pa·s.

Hereinafter, each component contained in the first agent and the second agent will be described in detail.

(Liquid resin (A-1) and (A-2))

Examples of the liquid resins (A-1) and (A-2) include, but are not particularly limited to, silicone resins, epoxy resins, acrylic resins, urethane resins, and phenol resins. Among them, silicone resins are preferred in terms of heat resistance and flexibility. The liquid resins (A-1) and (A-2) may be used alone or in combination of two or more. The term "liquid" refers to a liquid state in which the resin alone has fluidity at ambient temperature under ordinary pressure.

As the silicone resin, an addition reaction type silicone resin which is liquid at ambient temperature is preferred. Examples of the addition reaction type silicone resin include, but are not particularly limited to, a polyorganosiloxane having two or more alkenyl groups in a molecule and a polyorganosiloxane having three or more Si-H groups in a

molecule. The alkenyl group included in the polyorganosiloxane is preferably a vinyl group.

The first agent preferably contains either one of these polyorganosiloxanes, and more preferably contains a polyorganosiloxane having alkenyl groups, as the liquid resin (A-1). Consequently, the addition reaction between the alkenyl group and the Si-H group due to the hydrosilylation reaction catalyst (D-1) does not occur in the first agent. The second agent preferably contains either one of these polyorganosiloxanes, more preferably contains a polyorganosiloxane having Si-H groups, and further preferably contains both a polyorganosiloxane having alkenyl groups and a polyorganosiloxane having Si-H groups, as the liquid resin (A-2).

In the polyorganosiloxane having alkenyl groups, the binding portion of the alkenyl group is not particularly limited, and the alkenyl group may be bonded to a side chain and/or a terminal of the polyorganosiloxane. The number of alkenyl groups in the polyorganosiloxane having alkenyl groups is not particularly limited as long as it may be 2 or more, and is preferably 2 to 10, and more preferably 2 to 5. When the number of alkenyl groups falls within the above range, the change in hardness of the heat conductive grease to be obtained at high temperatures is further suppressed, and the viscosity is reduced, so that the application properties tend to be further improved.

Further, the alkenyl group content of the polyorganosiloxane having alkenyl groups is preferably 0.10 to 2.0 mol/kg, more preferably 0.10 to 1.0 mol/kg, and further preferably 0.10 to 0.6 mol/kg. When the alkenyl group content falls within the above range, the change in hardness of the heat conductive grease to be obtained at high temperatures is further suppressed and the viscosity is reduced, so that the application properties tend to be further improved. When the polyorganosiloxane has a vinyl group as the alkenyl group, the alkenyl group content is also referred to as the vinyl group content.

In the polyorganosiloxane having Si-H groups, the binding portion of the Si-H group is not particularly limited, and the Si-H group may be bonded to a side chain and/or a terminal of the polyorganosiloxane. The number of Si-H groups in the polyorganosiloxane having Si-H groups is not particularly limited as long as it may be 3 or more, and is preferably 3 to 60, more preferably 10 to 50, and further preferably 25 to 45. When the number of Si-H groups falls within the above range, the change in hardness of the heat conductive grease to be obtained at high temperatures is further suppressed and the viscosity is reduced, so that the application properties tend to be further improved.

Further, the Si-H group content of the polyorganosiloxane having Si-H groups is preferably 1.0 to 15 mol/kg, more preferably 3.0 to 12 mol/kg, and further preferably 5.0 to 10 mol/kg. When the Si-H group content falls within the above range, the change in hardness of the heat conductive grease to be obtained at high temperatures is further suppressed and the viscosity is reduced, so that the application properties tend to be further improved.

The polyorganosiloxane having alkenyl groups on a side chain may have a constitutional unit represented by, for example, the following formula (1). The polyorganosiloxane having Si-H groups on a side chain may have a constitutional unit represented by, for example, the following formula (2).

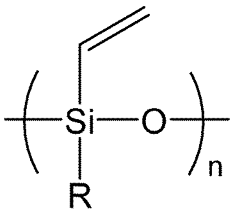
(1)

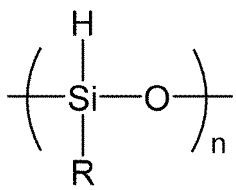
(2)

In the above formulas (1) and (2), each R independently represents, for example, alkyl groups such as a methyl group, an ethyl group, a propyl group, a hexyl group, an octyl group, a decyl group, a dodecyl group, a tetradecyl group, a hexadecyl group, and an octadecyl group; cycloalkyl groups such as a cyclopentyl group and a cyclohexyl group; aryl groups such as a phenyl group and a tolyl group; aralkyl groups such as a 2-phenylethyl group and a 2-methyl-2-phenylethyl group; and halogenated hydrocarbon groups such as a 3,3,3-trifluoropropyl group, a 2-(perfluorobutyl)ethyl group, a 2-(perfluorooctyl)ethyl group, and a p-chlorophenyl group.

Among them, R is preferably an alkyl group or an aryl group, and more preferably a methyl group, a phenyl group, or an alkyl group having 6 to 18 carbon atoms.

In the above formulas (1) and (2), n represents a number of repetitions of the constitutional unit. n may be similar to the number of the alkenyl group or the Si-H group that the polyorganosiloxane has on the side chain.

Among the above, the liquid resin (A-1) preferably includes the polyorganosiloxane (A-1-1) having two or more alkenyl groups in a molecule and having a viscosity at 25°C and a shear rate of 10 $s^{-1}$ of 50 to 3000 mPa·s. The liquid resin (A-2) preferably includes at least a polyorganosiloxane (A-2-1) having two or more alkenyl groups in a molecule and having a viscosity at 25°C and a shear rate of 10 $s^{-1}$ of 50 to 3000 mPa·s and a polyorganosiloxane (A-2-2) having at least three or more Si-H groups on both terminals or the side chain. Consequently, mixing the first agent and the second agent allows the hydrosilylation reaction to proceed further effectively, so that a cross-linked cured product that has a three-dimensional network structure having a crosslinking bond can be obtained.

The viscosity at 25°C and a shear rate of 10 $s^{-1}$ of the polyorganosiloxanes (A-1-1) and (A-2-1) is preferably 50 to 3000 mPa·s, more preferably 50 to 1000 mPa·s, and further preferably 50 to 500 mPa·s. When the viscosity of the polyorganosiloxanes (A-1-1) and (A-2-1) is 50 mPa·s or more, the change in hardness of the heat conductive grease to be obtained at high temperatures tends to be further suppressed. When the viscosity of the polyorganosiloxanes (A-1-1) and (A-2-1) is 3000 mPa·s or less, the viscosity of the heat conductive grease to be obtained tends to be reduced and the application properties tend to be further improved.

The viscosity at 25°C and a shear rate of 10 $s^{-1}$ of the polyorganosiloxane (A-2-2) is preferably 10 to 1000 mPa·s, more preferably 10 to 500 mPa·s, and further preferably 10 to 200 mPa·s. When the viscosity of the polyorganosiloxane (A-2-2) is 10 mPa·s or more, the change in hardness of the heat conductive grease to be obtained at high temperatures tends to be further suppressed. When the viscosity of the polyorganosiloxane (A-2-2) is 1000 mPa·s or less, the viscosity of the heat conductive grease to be obtained is reduced, so that the application properties tend to be further improved. In the case of the first agent containing a polyorganosiloxane having Si-H groups, the viscosity of the polyorganosiloxane may be the same as that of the above polyorganosiloxane (A-2-2).

The viscosity of each component contained in the liquid resins (A-1) and (A-2) can be measured by a conventional method using a viscometer.

The content of the liquid resin (A-1) or (A-2) is preferably 2.0 to 25% by mass, more preferably 4.0 to 18% by mass, and further preferably 6.0 to 13% by mass based on the total amount of the first agent or the second agent, respectively. When the content of the liquid resin (A-1) or (A-2) falls within the above range, the change in hardness of the heat conductive grease to be obtained at high temperatures is further prevented and the viscosity is reduced, so that the application properties tend to be further improved.

Further, the content of the polyorganosiloxane (A-1-1) or (A-2-1) is preferably 70 to 100% by mass, more preferably 80 to 100% by mass, and further preferably 90 to 100% by mass based on the total amount of the liquid resin (A-1) or (A-2), respectively. When the content of the polyorganosiloxane (A-1-1) or (A-2-1) falls within the above range, the change in hardness of the heat conductive grease to be obtained at high temperatures is further prevented and the viscosity is reduced, so that the application properties tend to be further improved.

In the case of the second agent containing both the polyorganosiloxane having alkenyl groups and the polyorganosiloxane having Si-H groups, the content of the polyorganosiloxane having Si-H groups in the second agent is preferably 0.5 to 15 parts by weight, more preferably 1.5 to 10 parts by weight, and further preferably 2.5 to 5.0 parts by weight per 100 parts by weight in total of the polyorganosiloxane having alkenyl groups and the polyorganosiloxane having Si-H groups.

The ratio of the sum of number of moles of the alkenyl group in the liquid resin (A-1) and the liquid resin (A-2) contained in the first agent and the second agent to number of moles of the Si-H group in the liquid resin (A-2) contained in the second agent is preferably 0.1 to 5.0, more preferably 1.0 to 4.0, and further preferably 1.5 to 3.5. When the above ratio is 0.1 or more, the curing properties of the heat conductive grease tend to be further improved. When the above ratio is 5.0 or less, the embrittlement of the heat conductive grease is further suppressed, so that a suitable elastic body tends to be obtained.

(Metal aluminum (B-1) and (B-2))

The average particle size of the metal aluminum (B-1) and (B-2) is 15 to 100 μm, preferably 20 to 80 μm, more preferably 20 to 60 μm, and further preferably 20 to 40 μm. When the average particle size of the metal aluminum (B-1) and (B-2) is 15 μm or more, the heat conductivity of the heat conductive grease to be obtained can be improved. When the average particle size of the metal aluminum (B-1) and (B-2) is 100 μm or less, the storage stability of the heat conductive grease to be obtained becomes more favorable, so that the separation of the liquid resins (A-1) and (A-2) from the metal aluminum (B-1) and (B-2) is further suppressed.

The average particle size of the metal aluminum (B-1) and (B-2) is a median size, and can be measured by the method described in Examples. The metal aluminum (B-1) and (B-2) may be the same or different from each other.

The metal aluminum (B-1) and (B-2) may be used each alone or two or more kinds of metal aluminum each having a different average particle size may be used. When a plurality of kinds of metal aluminum (B-1) and (B-2) is used, each of them should be included within the above range. Therefore, for example, even when metal aluminum having an average particle size of less than 15 μm and metal aluminum having an average particle size of more than 100 μm are mixed, the metal aluminum after mixing does not correspond to the metal aluminum (B-1) and (B-2) of the present embodiment.

Examples of the shape of the metal aluminum (B-1) and (B-2) include, but are not particularly limited to, spherical and indefinite shape. Among them, spherical is preferred. By having such a shape, the viscosity tends to be further reduced, while improving the amount of the metal aluminum (B-1) and (B-2) to be filled.

The content of the metal aluminum (B-1) or (B-2) is 140 to 560 parts by weight, preferably 200 to 500 parts by weight, and more preferably 200 to 400 parts by weight per 100 parts by weight of the liquid resin (A-1) or (A-2),

respectively. When the content of the metal aluminum (B-1) or (B-2) is 140 parts by weight or more, the heat conductivity of the heat conductive grease to be obtained is further improved. When the content of the metal aluminum (B-1) or (B-2) is 560 parts by weight or less, the insulating properties of the heat conductive grease are further improved.

Further, the volume proportion of the metal aluminum (B-1) or (B-2) is preferably 5 to 70% by volume, more preferably 15 to 50% by volume, and further preferably 20 to 40% by volume based on the sum of the heat conductive filler (C-1) and the metal aluminum (B-1) or the sum of the heat conductive filler (C-2) and the metal aluminum (B-2), respectively. When the volume proportion of the metal aluminum (B-1) or (B-2) falls within the above range, the heat conductivity of the heat conductive grease tends to be further improved, the viscosity thereof tends to be further reduced, and the application properties thereof tend to be further improved.

(Heat conductive fillers (C-1) and (C-2))

The heat conductive fillers (C-1) and (C-2) are at least one or more selected from the group consisting of aluminum oxide, aluminum nitride, and boron nitride. The heat conductive fillers (C-1) and (C-2) each having a different material may be used alone or in combination of two or more. Among them, the heat conductive fillers (C-1) and (C-2) preferably include at least aluminum oxide. By using such heat conductive fillers (C-1) and (C-2), the heat conductive filler (C-1) and/or the heat conductive filler (C-2) enters the gap in the metal aluminum (B-1) and/or the metal aluminum (B-2), so that the heat conductivity of the heat conductive grease to be obtained is further improved.

The average particle size of the heat conductive fillers (C-1) and (C-2) is 0.30 to 10 μm, and preferably 0.40 to 7.0 μm. When the average particle size of the heat conductive fillers (C-1) and (C-2) falls within the above range, the heat conductive filler (C-1) and/or the heat conductive filler (C-2) easily enters the gap in the metal aluminum (B-1) and/or the metal aluminum (B-2). When the average particle size of the heat conductive fillers (C-1) and (C-2) is 0.30 μm or more, the viscosity of the heat conductive grease is reduced and the application properties are further improved. When the average particle size of the heat conductive fillers (C-1) and (C-2) is 10 μm or less, the heat conductive filler (C-1) and/or the heat conductive filler (C-2) enters the gap in the metal aluminum (B-1) and/or the metal aluminum (B-2) and can be highly filled, so that the heat conductivity of the heat conductive grease is further improved.

The heat conductive fillers (C-1) and (C-2) may be used each alone or two or more fillers each having a different mean diameter or material may be used. When a plurality of kinds of heat conductive fillers (C-1) and (C-2) is used, each of them should be included within the above range. Therefore, for example, even when an aluminum oxide having an average particle size of less than 0.30 μm and an aluminum oxide having an average particle size of more than 10 μm are mixed, the aluminum oxide after mixing does not correspond to the heat conductive fillers (C-1) and (C-2) of the present embodiment.

The average particle size of the heat conductive fillers (C-1) and (C-2) is a median size, and can be measured by the method described in Examples. The heat conductive fillers (C-1) and (C-2) may be the same or different from each other.

Further, the heat conductive filler (C-1) may include at least one of a first heat conductive filler (C-1-1) having an average particle size of 0.30 to 1.5 μm, a second heat conductive filler (C-1-2) having an average particle size of 1.6 to 3.5 μm, and a third heat conductive filler (C-1-3) having an average particle size of 3.7 to 10 μm. Among them, the heat conductive filler (C-1) preferably includes the first heat conductive filler (C-1-1), and more preferably includes the first heat conductive filler (C-1-1), the second heat conductive filler (C-1-2), and the third heat conductive filler (C-1-3). Consequently, the viscosity of the heat conductive grease is reduced, so that the application properties are further improved and the heat conductivity tends to be further improved.

The heat conductive filler (C-2) may include at least one of a first heat conductive filler (C-2-1) having an average particle size of 0.30 to 1.5 μm, a second heat conductive filler (C-2-2) having an average particle size of 1.6 to 3.5 μm, and a third heat conductive filler (C-2-3) having an average particle size of 3.7 to 10 μm. Among them, the heat conductive filler (C-2) preferably includes the first heat conductive filler (C-2-1), and more preferably includes the first heat conductive filler (C-2-1), the second heat conductive filler (C-2-2), and the third heat conductive filler (C-2-3). Consequently, the viscosity of the heat conductive grease is reduced, so that the application properties are further improved and the heat conductivity tends to be further improved.

In the present embodiment, at least one of the heat conductive filler (C-1) contained in the first agent or the heat conductive filler (C-2) contained in the second agent includes the first heat conductive filler (C-1-1) or the first heat conductive filler (C-2-1). When the first agent and/or the second agent contains the first heat conductive filler, the viscosity of the heat conductive grease is reduced, so that the application properties are further improved and the heat conductivity is further improved.

The content of the first heat conductive filler (C-1-1) or (C-2-1) is preferably 10 to 400 parts by weight, more preferably 50 to 300 parts by weight, and further preferably 100 to 250 parts by weight per 100 parts by weight of the liquid resin (A-1) or (A-2), respectively. When the content of the first heat conductive filler (C-1-1) or (C-2-1) falls within the above range, the viscosity of the heat conductive grease is reduced, so that the application properties are further

improved and the heat conductivity tends to be further improved.

The content of the second heat conductive filler (C-1-2) or (C-2-2) is preferably 50 to 700 parts by weight, more preferably 100 to 500 parts by weight, and further preferably 150 to 450 parts by weight per 100 parts by weight of the liquid resin (A-1) or (A-2), respectively. When the content of the second heat conductive filler (C-1-2) or (C-2-2) falls within the above range, the viscosity of the heat conductive grease is reduced, so that the application properties are further improved and the heat conductivity tends to be further improved.

The content of the third heat conductive filler (C-1-3) or (C-2-3) is preferably 200 to 900 parts by weight, more preferably 300 to 800 parts by weight, and further preferably 400 to 700 parts by weight per 100 parts by weight of the liquid resin (A-1) or (A-2), respectively. When the content of the third heat conductive filler (C-1-3) or (C-2-3) falls within the above range, the viscosity of the heat conductive grease is reduced, so that the application properties are further improved and the heat conductivity tends to be further improved.

Examples of the shape of the heat conductive fillers (C-1) and (C-2) include, but are not particularly limited to, spherical and indefinite shape. Among them, spherical is preferred. By having such a shape, the viscosity tends to be further reduced, while improving the amount of the heat conductive fillers (C-1) and (C-2) to be filled.

The content of the heat conductive filler (C-1) or (C-2) is preferably 300 to 1800 parts by weight, more preferably 400 to 1700 parts by weight, further preferably 700 to 1500 parts by weight, and still more preferably 800 to 1250 parts by weight per 100 parts by weight of the liquid resin (A-1) or (A-2), respectively. When the content of the heat conductive filler (C-1) or (C-2) is 300 parts by weight or more, the gap in the metal aluminum (B-1) and/or the metal aluminum (B-2) can be filled, so that the heat conductivity of the heat conductive grease to be obtained tends to be further improved. When the content of the heat conductive filler (C-1) or (C-2) is 1800 parts by weight or less, the viscosity of the heat conductive grease to be obtained is further reduced, so that the application properties tend to be further improved.

(Hydrosilylation reaction catalyst (D-1)

Examples of the hydrosilylation reaction catalyst (D-1) include, but are not particularly limited to, platinum compound catalysts, rhodium compound catalysts, and palladium compound catalysts. Among them, a platinum compound catalyst is preferred. By using such a hydrosilylation reaction catalyst (D-1), the curing properties of the liquid resin (A-1), (A-2) tend to be further improved.

Examples of the platinum compound catalyst include, but are not particularly limited to, a platinum single body, platinum compounds, and platinum-supporting inorganic powder. Examples of platinum compounds include, but are not particularly limited to, chloroplatinic acid, a platinum-olefin complex, a platinum-alcohol complex, and a platinum coordination compound. Examples of the platinum-supporting inorganic powder include, but are not particularly limited to, platinum-supporting alumina powder, platinum-supporting silica powder, and platinum-supporting carbon powder. The platinum compound catalyst may be blended singly when the first agent is prepared, or may be blended in a state of being mixed with another component, for example, the liquid resin (A-1) in advance.

The content of the hydrosilylation reaction catalyst (D-1) is preferably 0.1 to 500 ppm, more preferably 1.0 to 400 ppm, and further preferably 10 to 200 ppm per 100 parts by weight of the liquid resin (A-1) or (A-2). When the content of the hydrosilylation reaction catalyst (D-1) falls within the above range, the curing properties of the liquid resin (A-1), (A-2) tend to be further improved.

(Other additive (E-1) and (E-2))

In addition to the above components, the first agent and the second agent may respectively contain additives (E-1) and (E-2) such as an organosilane other than the above liquid resins (A-1) and (A-2), a colorant, and a reaction retarder as needed.

Examples of the above organosilane include, but are not particularly limited to, an organosiloxane represented by the following general formula (3). By using such an organosilane, the wettability of the liquid resins (A-1) and (A-2) to the above heat conductive fillers (C-1) and (C-2) is further improved, the viscosity is reduced, and the heat conductivity tends to be further improved.

$$R^1_aR^2_bSi(OR^3)_{4-(a+b)} \qquad (3)$$

(each $R^1$ is independently an alkyl group having 1 to 15 carbon atoms, each $R^2$ is independently a saturated or unsaturated monovalent hydrocarbon group having 1 to 8 carbon atoms, each $R^3$ is independently an alkyl group having 1 to 6 carbon atoms, a is 1 to 3, b is 0 to 2, and a + b is 1 to 3.)

In the formula (3), each $R^1$ is independently an alkyl group having 1 to 15 carbon atoms, and examples thereof include, but are not particularly limited to, a methyl group, an ethyl group, a propyl group, a hexyl group, a nonyl group, a decyl group, a dodecyl group, and a tetradecyl group. Among them, $R^1$ is preferably an alkyl group having 6 to 12

carbon atoms.

$R^2$ is a saturated or unsaturated monovalent hydrocarbon group having 1 to 8 carbon atoms, and examples thereof include, but are not particularly limited to, alkyl groups such as a methyl group, an ethyl group, a propyl group, a hexyl group, an octyl group; cycloalkyl groups such as a cyclopentyl group and a cyclohexyl group; alkenyl groups such as a vinyl group and an allyl group; aryl groups such as a phenyl group and a tolyl group; aralkyl groups such as a 2-phenylethyl group and a 2-methyl-2-phenylethyl group; and halogenated hydrocarbons groups such as a 3,3,3-trifluoropropyl group, a 2-(perfluorobutyl)ethyl group, a 2-(perfluorooctyl)ethyl group, and a p-chlorophenyl group.

$R^3$ is preferably one or two or more alkyl groups having 1 to 6 carbon atoms, such as a methyl group, an ethyl group, a propyl group, a butyl group, a pentyl group, and a hexyl group, and is preferably a methyl group or an ethyl group.

a is an integer of 1 to 3, and is preferably 1. b is an integer of 0 to 2, and is preferably 0. Further, a + b is an integer of 1 to 3, and is preferably 1.

The content of the organosilane contained in the first agent or the second agent is preferably 0.01 to 10 parts by weight, and more preferably 0.1 to 5.0 parts by weight per 100 parts by weight in total of the metal aluminum (B-1) or (B-2) and the heat conductive filler (C-1) or (C-2), respectively. When the content of the organosilane falls within the above range, the wettability can be effectively improved.

The content of the colorant contained in the first agent or the second agent is preferably 0.05 to 0.2 parts by weight per 100 parts by weight in total of the first agent or the second agent, respectively.

Examples of the reaction retarder include, but are not particularly limited to, 1-ethynyl-1-cyclohexanol.

The content of the reaction retarder is preferably 0.05 to 0.2 parts by weight per 100 parts by weight in total of the first agent or the second agent.

[Heat conductive grease]

The heat conductive grease of the present embodiment is obtained by curing the first agent and the second agent contained in the above two-agent curable heat conductive grease composition. The term "curing" includes a semi-cured product of the first agent and the second agent. For example, a two-agent curable heat conductive grease composition in which the hydrosilylation reaction has partially proceeded in advance can be used as the heat conductive grease.

The heat conductivity at 25°C of the heat conductive grease is preferably 0.5 W/mK or more, more preferably 1.0 W/mK or more, and further preferably 2.0 W/mK or more. When the heat conductivity is 0.5 W/mK or more, favorable heat dissipation to electronic components can be obtained. The heat conductivity can be measured by the method described in Examples.

The breakdown voltage per 1 mm thickness of the heat conductive grease is preferably 1.0 kV or more, and more preferably 1.5 kV or more. When the breakdown voltage is 1.0 kV or more, sufficient electrical insulating properties are secured. The breakdown voltage can be measured in accordance with JIS C2110.

[Electronic device]

The electronic device of the present embodiment is obtained by arranging a heating generating element and a metal casing via the above heat conductive grease.

Here, examples of the heating generating element include, but are not particularly limited to, heat generating electronic components such as motors, battery packs, circuit substrates used in on-board power supply systems, power transistors, and microprocessors. Among them, electronic components used in on-board power supply systems for vehicles are preferred. Examples of the metal casing include, but are not particularly limited to, heat sinks that are configured to dissipate and absorb heat.

## Examples

Hereinafter, the present invention will be described in more detail by way of Examples, but the present invention is not limited to the following examples.

<A: Liquid resin>

a-1: Vinyl group-containing polyorganosiloxane (manufactured by Elkem Silicones, product name "621V100", viscosity at 25°C and a shear rate of 10 $s^{-1}$: 100 mPa·s, vinyl group content: 0.33 mol/kg, average number of vinyl groups in a molecule: 2).

a-2: SiH Group-containing polyorganosiloxane (manufactured by Elkem Silicones, product name "626V25H7", viscosity at 25°C and a shear rate of 10 $s^{-1}$: 25 mPa·s, Si-H group content: 7 mol/kg, average number of Si-H groups in a molecule: 36).

<B: Metal aluminum>

b-1: Average particle size: 25 μm, spherical, manufactured by HIKARI MATERIAL INDUSTRY CO., LTD., product name "Al-99.7% (-38 μm)".
b-2: Average particle size: 20 μm, spherical, manufactured by TOYO ALUMINIUM K.K., product name "TFH-A20P".
b-3: Average particle size: 48 μm, spherical, manufactured by HIKARI MATERIAL INDUSTRY CO., LTD., product name "Al-99.7% (-63 μm)".
b-4: Average particle size: 66 μm, spherical, manufactured by HIKARI MATERIAL INDUSTRY CO., LTD., product name "Al-99.7% (-150 μm)".

<C: Heat conductive filler>

c-1: Aluminum oxide, average particle size: 5 μm, spherical, manufactured by Sumitomo Chemical Company, Limited, product name "AA-5".
c-2: Aluminum oxide, average particle size: 2 μm, spherical, manufactured by Sumitomo Chemical Company, Limited, product name "AA-2".
c-3: Aluminum oxide, average particle size: 0.5 μm, spherical, manufactured by Sumitomo Chemical Company, Limited, product name "AA-0.5".
c-4: Aluminum nitride, average particle size: 5 μm, spherical, manufactured by MARUWA CO., LTD., product name "A-05-F".
c-5: Aluminum nitride, average particle size: 1 μm, spherical, manufactured by MARUWA CO., LTD., product name "A-01-F".
c-6: Boron nitride, average particle size: 5 μm, scaly, manufactured by Denka Company Limited., product name "HGP".
c-7: Zinc oxide, average particle size: 0.5 μm, spherical, manufactured by The Honjo Chemical Corporation, product name "zinc oxide grade 1".

<D: Hydrosilylation reaction catalyst>

Platinum compound catalyst: manufactured by Elkem Japan K.K., product name "SILCOLEASE CATA 12070".

<E: Organosilane>

e-1: n-Decyltrimethoxysilane (manufactured by Dow Toray Co., Ltd., product name "Z-6210").

[Examples 1 to 10 and Comparative Examples 1 to 3]

Each raw material was blended in a 2 L trimix apparatus in a proportion shown in Table 1 to Table 3 and kneaded under reduced pressure at ambient temperature to prepare the first agent and the second agent of each heat conductive grease composition. Unless otherwise indicated, the description about the amount of each component in Tables means parts by weight.

(Measurement of average particle size)

The average particle size of the metal aluminum B and the heat conductive filler C was measured using "laser diffraction particle size measuring apparatus SALD-20" manufactured by SHIMADZU CORPORATION. The evaluation sample was prepared by adding 50 mL of pure water and 5 g of metal aluminum B or heat conductive filler C to be measured into a glass beaker, stirring the mixture using a spatula, and then subjecting the mixture to dispersion treatment in an ultrasonic cleaning machine for 10 minutes. The dispersion liquid of the metal aluminum B or the heat conductive filler C being subjected to dispersion treatment was added dropwise to the sampler unit of the apparatus using a dropper,

and the measurement was carried out when the absorbance was stabilized. As for the average particle size, D50 (median size) was adopted.

(Measurement of viscosity)

Each viscosity of the polyorganosiloxane a-1, a-2, the first agent, the second agent, and the heat conductive grease was measured using a rotational rheometer "HANKE MARS III" (manufactured by Thermo Fisher Scientific K.K.). As the viscosity, a value obtained by using a parallel plate having a diameter of 35 mmφ under conditions of a gap of 0.5 mm, a temperature of 25°C, and a shear rate of 10 $s^{-1}$ was used. The viscosity of the heat conductive grease obtained by mixing the first agent and the second agent with a static mixer at a volume ratio of 1:1, that is, the mixed viscosity of the first agent and the second agent was measured in the same manner as above.

[Evaluation of application property]

Each of the first agent and the second agent was charged in a dual syringe (capacity: 25 cc × 2, manufactured by MIXPAC), a hand gun and a static mixer were attached thereto, and the first agent and the second agent were discharged at 25°C. Based on the discharged state, the application properties when the first agent and the second agent were mixed were evaluated. Evaluation criteria are shown below.

○: Easily dischargeable by a static mixer
△: Dischargeable by a static mixer, but a certain force (approximately 10 Kgf) was needed
×: Non-dischargeable by a static mixer

[Evaluation of heat conductivity]

The heat conductivity of the heat conductive grease was measured by a method in accordance with ASTM D5470 using a resin material heat resistance measuring apparatus (manufactured by Hitachi Technologies and Services, Ltd.). Specifically, mixtures obtained by mixing the first agent and the second agent with a static mixer in a volume ratio of 1:1, each having a thickness of 0.2 mm, 0.5 mm, and 1.0 mm, were sandwiched between copper jigs having an area of 10 mm × 10 mm, and heat resistance values at each thickness were measured. Based on the inclination of the straight line L obtained by taking the heat resistance value (°C/W) as the ordinate and the thickness (mm) of the heat conductive resin composition as the abscissa, the heat conductivity of the heat conductive resin composition was calculated by the following expression:

$$\text{Heat conductivity (W/mK)} = 10/L.$$

[Evaluation of breakdown voltage]

As the sample for the breakdown voltage, the first agent and the second agent were mixed with a static mixer at a volume ratio of 1:1, and then the mixture was formed into a state having a thickness of 1 mm and held for 24 hours to proceed the curing reaction, thereby obtaining a heat conductive grease cured body. Then, the heat conductive grease cured body obtained was punched into a square of 50 mm, a weight of 25 mmφ was placed on the heat conductive grease cured body, and voltage was applied to the weight by the method in accordance with JIS C2101 from 0 kV every 0.2 kV (DC). When the grease cured body was able to hold insulation properties at a voltage for 20 seconds, the voltage was determined as clear, and the maximum value cleared was taken as the breakdown voltage.

[Table 1]

| | | Example 1 | | Example 2 | | Example 3 | | Example 4 | | Example 5 | |
|---|---|---|---|---|---|---|---|---|---|---|---|
| | | First agent | Second agent | First agent | Second agent | First agent | Second agent | First agent | Second agent | First agent | Second agent |
| Liquid resin A | a-1: Vinyl group-containing polyorganosiloxane | 100 | 96.5 | 100 | 96.5 | 100 | 96.5 | 100 | 96.5 | 100 | 96.5 |
| | a-2: SiH group-containing polyorganosiloxane | | 3.5 | | 3.5 | | 3.5 | | 3.5 | | 3.5 |
| | Mole ratio of alkenyl group to Si-H group | 2.65 | | 2.65 | | 2.65 | | 2.65 | | 2.65 | |
| Metal aluminum B | b-1: Metal aluminum, average particle size: 25μm | 147 | 147 | 347 | 347 | 554 | 554 | 149 | 149 | 495 | 495 |
| | b-2: Metal aluminum, average particle size: 20μm | | | | | | | | | | |
| | b-3: Metal aluminum, average particle size: 48μm | | | | | | | | | | |
| | b-4: Metal aluminum, average particle size: 66μm | | | | | | | | | | |

(continued)

| | | Example 1 | | Example 2 | | Example 3 | | Example 4 | | Example 5 | |
|---|---|---|---|---|---|---|---|---|---|---|---|
| | | First agent | Second agent | First agent | Second agent | First agent | Second agent | First agent | Second agent | First agent | Second agent |
| Heat conductive filler C | c-1: Aluminum oxide, average particle size: 5μm | 213 | 213 | 504 | 504 | 806 | 806 | 659 | 659 | 388 | 388 |
| | c-2: Aluminum oxide, average particle size: 2μm | 128 | 128 | 302 | 302 | 483 | 483 | 395 | 395 | 233 | 233 |
| | c-3: Aluminum oxide, average particle size: 0.5μm | 55 | 55 | 130 | 130 | 207 | 207 | 169 | 169 | 100 | 100 |
| | c-4: Aluminum nitride, average particle size: 5μm | | | | | | | | | | |
| | c-5: Aluminum nitride, average particle size: 1 μm | | | | | | | | | | |
| | c-6: Boron nitride, average particle size: 5μm | | | | | | | | | | |
| | c-7: Zinc oxide, average particle size: 0.5μm | | | | | | | | | | |
| | Volume proportion of component B to sum of component B and component C (%) | 35 | 35 | 35 | 35 | 35 | 35 | 15 | 15 | 50 | 50 |
| Hydrosilylation reaction catalyst D *1 | | 50ppm | | 50ppm | | 50ppm | | 50ppm | | 50ppm | |
| Organosilane E | e-1: n-Decyltrimethoxysilane | 1.2 | 1.2 | 2.5 | 2.5 | 3.9 | 3.9 | 2.6 | 2.6 | 2.4 | 2.4 |
| Composition | Viscosity (Pa·s) | 30 | 30 | 100 | 90 | 260 | 250 | 130 | 120 | 90 | 85 |
| | Application property | ○ | | ○ | | Δ | | ○ | | ○ | |
| Heat conductive grease | Mixed viscosity of first agent and second agent (Pa·s) | 30 | | 100 | | 270 | | 130 | | 90 | |
| | Heat conductivity (W/mK) | 2.5 | | 4.1 | | 5.7 | | 3.7 | | 4.4 | |
| | Breakdown voltage (kV) | 8.2 | | 5 | | 2 | | 6.3 | | 2.1 | |

*1: Content to sum of component B and component C (ppm)

[Table 2]

| | | Example 6 | | Example 7 | | Example 8 | | Example 9 | | Example 10 | |
|---|---|---|---|---|---|---|---|---|---|---|---|
| | | First agent | Second agent | First agent | Second agent | First agent | Second agent | First agent | Second agent | First agent | Second d agent |
| Liquid resin A | a-1: Vinyl group-containing polyorganosiloxane | 100 | 96.5 | 100 | 96.5 | 100 | 96.5 | 100 | 96.5 | 100 | 96.5 |
| | a-2: SiH group-containing polyorganosiloxane | | 3.5 | | 3.5 | | 3.5 | | 3.5 | | 3.5 |
| | Mole ratio of alkenyl group to Si-H group | 2.65 | | 2.65 | | 2.65 | | 2.65 | | 2.65 | |
| Metal aluminum B | b-1: Metal aluminum, average particle size: 25μm | | | | | | | 347 | 347 | 347 | 347 |
| | b-2: Metal aluminum, average particle size: 20μm | 347 | 347 | | | | | | | | |
| | b-3: Metal aluminum, average particle size: 48μm | | | 347 | 347 | | | | | | |
| | b-4: Metal aluminum, average particle size: 66μm | | | | | 347 | 347 | | | | |

(continued)

| | | Example 6 | | Example 7 | | Example 8 | | Example 9 | | Example 10 | |
|---|---|---|---|---|---|---|---|---|---|---|---|
| | | First agent | Second agent | First agent | Second agent | First agent | Second agent | First agent | Second agent | First agent | Second agent |
| Heat conductive filler C | c-1: Aluminum oxide, average particle size: 5μm | 504 | 504 | 504 | 504 | 504 | 504 | | | 504 | 504 |
| | c-2: Aluminum oxide, average particle size: 2μm | 302 | 302 | 302 | 302 | 302 | 302 | | | | |
| | c-3: Aluminum oxide, average particle size: 0.5μm | 130 | 130 | 130 | 130 | 130 | 130 | 130 | 130 | 130 | 130 |
| | c-4: Aluminum nitride, average particle size: 5μm | | | | | | | 417 | 417 | | |
| | c-5: Aluminum nitride, average particle size: 1 μm | | | | | | | 250 | 250 | | |
| | c-6: Boron nitride, average particle size: 5μm | | | | | | | | | 169 | 169 |
| | c-7: Zinc oxide, average particle size: 0.5μm | | | | | | | | | | |
| | Volume proportion of component B to sum of component B and component C (%) | 35 | 35 | 35 | 35 | 35 | 35 | 35 | 35 | 35 | 35 |
| Hydrosilylation reaction catalyst D *1 | | 50ppm | | 50ppm | | 50ppm | | 50ppm | | 50ppm | |
| Organosilane E | e-1: n-Decyltrimethoxysilane | 2.5 | 2.5 | 2.5 | 2.5 | 2.5 | 2.5 | 0.9 | 0.9 | 1.9 | 1.9 |
| Composition | Viscosity (Pa·s) | 180 | 180 | 170 | 170 | 150 | 150 | 200 | 200 | 240 | 240 |
| | Application property | ○ | | ○ | | ○ | | ○ | | Δ | |
| Heat conductive grease | Mixed viscosity of first agent and second agent (Pa·s) | 180 | | 170 | | 150 | | 200 | | 250 | |
| | Heat conductivity (W/mK) | 4.2 | | 4.3 | | 4.5 | | 4.3 | | 4.4 | |
| | Breakdown voltage (kV) | 5 | | 3.9 | | 2.8 | | 4.8 | | 4.7 | |

*1: Content to sum of component B and component C (ppm)

[Table 3]

| | | Comparative Example 1 | | Comparative Example 2 | | Comparative Example 3 | |
|---|---|---|---|---|---|---|---|
| | | First agent | Second agent | First agent | Second agent | First agent | Second agent |
| Liquid resin A | a-1: Vinyl group-containing polyorganosiloxane | 100 | 96.5 | 100 | 96.5 | 100 | 96.5 |
| | a-2: SiH group-containing polyorganosiloxane | | 3.5 | | 3.5 | | 3.5 |
| | Mole ratio of alkenyl group to Si-H group | 2.65 | | 2.65 | | 2.65 | |
| Metal aluminum B | b-1: Metal aluminum, average particle size: 25μm | 594 | 594 | 347 | 347 | 601 | 601 |
| | b-2: Metal aluminum, average particle size: 20μm | | | | | | |
| | b-3: Metal aluminum, average particle size: 48μm | | | | | | |
| | b-4: Metal aluminum, average particle size: 66μm | | | | | | |
| Heat conductive filler C | c-1: Aluminum oxide, average particle size: 5μm | 310 | 310 | 504 | 504 | 873 | 873 |
| | c-2: Aluminum oxide, average particle size: 2μm | 104 | 104 | 302 | 302 | 524 | 524 |
| | c-3: Aluminum oxide, average particle size: 0.5μm | 80 | 80 | | | 320 | 320 |
| | c-4: Aluminum nitride, average particle size: 5μm | | | | | | |
| | c-5: Aluminum nitride, average particle size: 1 μm | | | | | | |
| | c-6: Boron nitride, average particle size: 5μm | | | | | | |
| | c-7: Zinc oxide, average particle size: 0.5μm | | | 185 | 185 | | |
| | Volume proportion of component B to sum of component B and component C (%) | 60 | 60 | 35 | 35 | 35 | 35 |
| Hydrosilylation reaction catalyst D *1 | | 50ppm | | 50ppm | | 50ppm | |
| Organosilane E | e-1: n-Decyltrimethoxysilane | 2.2 | 2.2 | 2.7 | 2.7 | 4.6 | 4.6 |
| Composition | Viscosity (Pa·s) | 90 | 90 | 260 | 260 | 300 | 300 |
| | Application property | ○ | | × | | × | |

(continued)

| | | Comparative Example 1 | | Comparative Example 2 | | Comparative Example 3 | |
|---|---|---|---|---|---|---|---|
| | | First agent | Second agent | First agent | Second agent | First agent | Second agent |
| Heat conductive grease | Mixed viscosity of first agent and second agent (Pa·s) | 90 | | NA | | NA | |
| | Heat conductivity (W/mK) | 4.5 | | NA | | NA | |
| | Breakdown voltage (kV) | 0.4 | | NA | | NA | |
| *1: Content to sum of component B and component C (ppm) | | | | | | | |

Industrial Applicability

The two-agent curable heat conductive grease composition of the present invention is a composition for constituting a heat conductive grease by mixing and curing the first agent and the second agent, and has industrial application as a material for the heat conductive grease for use to thermally bond a heating generating element and a metal casing.

## Claims

1. A two-agent curable heat conductive grease composition comprising a first agent and a second agent, wherein

   the first agent contains 100 parts by weight of a liquid resin (A-1), 140 parts by weight to 560 parts by weight of metal aluminum (B-1) having an average particle size of 15 to 100 μm, one or more heat conductive fillers (C-1) selected from the group consisting of aluminum oxide, aluminum nitride, and boron nitride and having an average particle size within a range of 0.3 to 10 μm, and a hydrosilylation reaction catalyst (D-1);
   the second agent contains 100 parts by weight of a liquid resin (A-2), 140 parts by weight to 560 parts by weight of metal aluminum (B-2) having an average particle size of 15 to 100 μm, and one or more heat conductive fillers (C-2) selected from the group consisting of aluminum oxide, aluminum nitride, and boron nitride and having an average particle size within a range of 0.3 to 10 μm; and
   at least one of the heat conductive filler (C-1) or the heat conductive filler (C-2) comprises a first heat conductive filler (C-1-1) or a first heat conductive filler (C-2-1) being at least one or more selected from the group consisting of aluminum oxide, aluminum nitride, and boron nitride and having an average particle size of 0.3 to 1.5 μm.

2. The two-agent curable heat conductive grease composition according to claim 1, wherein

   the liquid resin (A-1) comprises a polyorganosiloxane (A-1-1) having two or more alkenyl groups in a molecule and having a viscosity at 25°C and a shear rate of 10 $s^{-1}$ of 50 to 3000 mPa·s, and
   the hydrosilylation reaction catalyst (D-1) comprises a platinum compound catalyst.

3. The two-agent curable heat conductive grease composition according to claim 1 or 2, wherein the liquid resin (A-2) comprises:

   a polyorganosiloxane (A-2-1) having two or more alkenyl groups in a molecule and having a viscosity at 25°C and a shear rate of 10 $s^{-1}$ of 50 to 3000 mPa·s, and
   a polyorganosiloxane (A-2-2) having three or more Si-H groups in a molecule.

4. The two-agent curable heat conductive grease composition according to any one of claims 1 to 3, wherein a ratio of the sum of number of moles of the alkenyl group in the liquid resin (A-1) and the liquid resin (A-2) contained in the first agent and the second agent to number of moles of the Si-H group in the liquid resin (A-2) contained in the second agent is 0.1 to 5.0.

5. The two-agent curable heat conductive grease composition according to any one of claims 1 to 4, wherein a viscosity at 25°C and a shear rate of 10 $s^{-1}$ of the first agent and the second agent is 20 Pa·s to 300 Pa·s.

**6.** A heat conductive grease obtained by curing the first agent and the second agent contained in the two-agent curable heat conductive grease composition according to any one of claims 1 to 5.

**7.** The heat conductive grease according to claim 6, wherein the heat conductive grease has

a heat conductivity of 0.5 W/mK or more, and
a breakdown voltage per 1 mm thickness of 1 kV or more.

**8.** An electronic device comprising a heating generating element and a metal casing arranged via the heat conductive grease according to claim 6 or 7.

# INTERNATIONAL SEARCH REPORT

International application No.
PCT/JP2021/020817

A. CLASSIFICATION OF SUBJECT MATTER
H01L 23/36(2006.01)i; C08K 5/5425(2006.01)i; C08L 83/05(2006.01)i; C08L 83/07(2006.01)i; C09K 5/14(2006.01)i; C08K 3/08(2006.01)i; C08K 3/22(2006.01)i; C08K 3/28(2006.01)i; C08K 3/38(2006.01)i
FI: C09K5/14 101E; C08L83/07; C08L83/05; C08K5/5425; C08K3/08; C08K3/22; C08K3/28; C08K3/38; H01L23/36
According to International Patent Classification (IPC) or to both national classification and IPC

B. FIELDS SEARCHED
Minimum documentation searched (classification system followed by classification symbols)
H01L23/36; C08K; C08L; C09K5/14; C10M; C10N; F21V29/503

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2020/080256 A1 (DENKA COMPANY LIMITED) 23 April 2020 (2020-04-23) claims, paragraphs [0017]-[0029], [0042], [0047]-[0059], examples | 1-8 |
| Y | JP 2005-170971 A (DENKI KAGAKU KOGYO KABUSHIKI KAISHA) 30 June 2005 (2005-06-30) examples 1-3 | 1-8 |
| Y | JP 2007-99821 A (MOMENTIVE PERFORMANCE MATERIALS JAPAN L. L. C.) 19 April 2007 (2007-04-19) example 2 | 1-8 |
| A | JP 2013-124257 A (SHIN-ETSU CHEMICAL CO., LTD.) 24 June 2013 (2013-06-24) claims, examples | 1-8 |

☐ Further documents are listed in the continuation of Box C.    ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 20 August 2021 (20.08.2021) | 31 August 2021 (31.08.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/020817

| Patent Documents referred in the Report | Publication Date | Patent Family | Publication Date |
|---|---|---|---|
| WO 2020/080256 A1 | 23 Apr. 2020 | JP 6727471 B1 | |
| JP 2005-170971 A | 30 Jun. 2005 | (Family: none) | |
| JP 2007-99821 A | 19 Apr. 2007 | (Family: none) | |
| JP 2013-124257 A | 24 Jun. 2013 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005170971 A
- JP 2010248669 A
- JP 2007099821 A